# EUROPEAN PATENT SPECIFICATION

(11) **EP 3 455 292 B1**
(45) Date of publication and mention of the grant of the patent: **23.06.2021**
(21) Application number: 17725815.9
(22) Date of filing: 11.05.2017
(51) Int. Cl.: C08K 3/22, C08K 7/02, C08K 9/02, G01R 1/04, H01R 12/70, H01R 13/24

(54) **POLYIMIDE COMPOSITIONS AND A POLYIMIDE TEST SOCKET HOUSING**
POLYIMIDZUSAMMENSETZUNG UND TESTSOCKELGEHÄUSE AUS POLYIMID
COMPOSITIONS POLYIMIDE ET BOÎTIER DE PRISE DE VÉRIFICATION

(30) Priority: 12.05.2016 US 201662335229 P; 12.05.2016 US 201662335222 P; 12.05.2016 US 201662335225 P
(43) Date of publication of application: 20.03.2019
(73) Proprietor: E. I. du Pont de Nemours and Company, Wilmington, DE 19805 (US)
(72) Inventor: SIMMONS, John W., Wilmington, Delaware 19803 (US); KRIZAN, Timothy D., Wilmington, Delaware 19810 (US)
(74) Representative: Dannenberger, Oliver Andre
(86) International application number: PCT/US2017/032093
(87) International publication number: WO 2017/197077

(56) References cited:
- EP-A1- 2 072 581
- WO-A2-2012/050972
- DE-U1- 20 316 645
- US-A1- 2011 056 539

## Description

### Field of the Invention

The disclosure generally relates to polyimide compositions, and articles such as test sockets and test sockets made from the aforementioned having improved mechanical properties. In particular, polyimide compositions comprising a polyimide and a titanium dioxide filler and test socket housings made of compositions comprising a polyimide and a titanium dioxide filler.

### Background of the Invention

Polyimide compositions are useful in a wide variety of applications due to the unique performance characteristics of polyimide compositions under stress and high temperatures. Polyimide compositions are described in WO 2012/050972 A2, EP 2 072 581 A1 and US 2011/056539 A1. Test sockets are used in back-end testing of finished and semi-finished semiconductor packages under a variety of stressed operational situations to evaluate performance characteristics of the semiconductor packages. A test socket often includes a test socket housing that is disposed between pads of a semiconductor package and terminals of a test board. Sockets and socket housings are described in DE 203 16 645 U1.

### Summary of the Invention

A first aspect of the present invention relates to a test socket housing having through-holes vertically extending through the housing, wherein the housing comprises: a) 40 wt% - 80 wt% polyimide polymer; and b) 20 wt% - 60 wt% rutile titanium dioxide or acicular titanium dioxide.

A second aspect of the present invention relates to a test socket comprising: a test socket housing having through-holes vertically extending through the housing, wherein the housing comprises: a) 40 wt% - 80 wt% polyimide polymer; and b) 20 wt% - 60 wt% rutile titanium dioxide or acicular titanium dioxide.

Further described is a polyimide composition comprising: a) 40 wt% - 80 wt% polyimide polymer; and b) 20 wt% - 60 wt% rutile titanium dioxide or acicular titanium dioxide.

Still further described is a polyimide composition comprising: a) 40 wt% - 80 wt% polyimide polymer; and b) 20 wt% - 60 wt% rutile titanium dioxide.

### Brief Description of the Drawings

FIG. 1 depicts an embodiment of a test socket, in accordance with the present disclosure;
FIG. 2 depicts an embodiment of a test socket housing, in accordance with the present disclosure;
FIG. 3 depicts another embodiment of a test socket housing, in accordance with the present disclosure;
FIG. 4 depicts another embodiment of a test socket housing, in accordance with the present disclosure; and
FIG. 5 depicts another embodiment of a test socket, in accordance with the present disclosure.

### Detailed Description of the Invention

### Abbreviations

The claims and description herein are to be interpreted using the abbreviations and definitions set forth below: "h", "hrs" refers to hours; "%" refers to the term percent; "mole %" refers to mole percent; "wt %" refers to weight percent; "parts" refers to parts by weight; and one of skill in the art uses and recognizes this term of measurement, "g" refers to grams.

### Definitions

As used herein, the article "a" refers to one as well as more than one and does not necessarily limit its referent noun to the grammatical category of singular number.

As used herein, the terms "about" and "at or about", when used to modify an amount or value, refers to an approximation of an amount or value that is more or less than the precise amount or value recited in the claims or described herein. The precise value of the approximation is determined by what one of skill in the art would recognize as an appropriate approximation to the precise value. As used herein, the term conveys that similar values, not precisely recited in the claims or described herein, can bring about results or effects that are equivalent to those recited in the claims or described herein, for which one of skill in the art would acknowledge as acceptably brought about by the similar values.

As used herein, the term "article" refers to an unfinished or finished item, thing, object, or an element or feature of an unfinished or finished item, thing or object. As used herein, when an article is unfinished, the term "article" may refer to any item, thing, object, element, device, etc. that has a form, shape, configuration that may undergo further processing in order to become a finished article. When an article is unfinished, the term "preform" may refer to that form, shape, configuration, any part of which may undergo further processing to become finished.

As used herein, when an article is finished, the term "article" refers to an item, thing, object, element, device, etc. that is in a form, shape, configuration that is suitable for a particular use/purpose without further processing of the entire entity or a portion of it.

An article may comprise one or more element(s) or subassembly(ies) that either are partially finished and awaiting further processing or assembly with other elements/subassemblies that together will comprise a finished article. In addition, as used herein, the term "article" may refer to a system or configuration of articles.

### Ranges and Preferred Variants

Any range set forth herein expressly includes its endpoints unless explicitly stated otherwise. Setting forth an amount, concentration, or other value or parameter as a range specifically discloses all possible ranges formed from any possible upper range limit and any possible lower range limit, regardless of whether such pairs of upper and lower range limits are expressly disclosed herein. Compounds, processes and articles described herein are not limited to specific values disclosed in defining a range in the description.

The disclosure herein of any variation in terms of materials, chemical entities, methods, steps, values, and/or ranges, etc.-whether identified as preferred or not-of the processes, compounds and articles described herein specifically intends to include any possible combination of materials, methods, steps, values, ranges, etc. For the purpose of providing photographic and sufficient support for the claims, any disclosed combination is a preferred variant of the processes, compounds, and articles described herein.

In this description, if there are nomenclature errors or typographical errors regarding the chemical name any chemical species described herein, including curing agents of formula (I), the chemical structure takes precedence over the chemical name. And, if there are errors in the chemical structures of any chemical species described herein, the chemical structure of the chemical species that one of skill in the art understands the description to intend prevails.

### Generally

The unique performance characteristics of polyimide compositions under stress and at high temperatures have made them useful in articles such as bushings, seals, electrical insulators, compressor vanes and impellers, pistons and piston rings, gears, thread guides, cams, brake linings, clutch faces, thrust plugs, and etc.

It is often desirable to incorporate various additives in such polyimide compositions and blends before fabrication into their final form. Graphite has been incorporated into polyimides to improve the wear and mechanical characteristics of such compositions.

Despite the variety of polyimide compositions and additives that have previously been available, there is a continuing need for polyimide compositions and blends which exhibit improved: wear resistance, friction at conditions of high pressure and velocity, mechanical properties under stress.

Applicants have discovered that polyimide compositions comprising polyimides and titanium dioxide fillers address the industry needs described herein.

Semiconductor processes are performed on a wafer of silicon or other semiconductive material to form a plurality of semiconductor chips. To mount the semiconductor ships on a printed circuit board (PCB), a packaging process is performed on the wafer to form semiconductor packages.

Electrical characteristics of the semiconductor package, which is manufactured by the above-mentioned processes, are tested. Using typical test methods, the semiconductor package is loaded into a test chamber wherein the semiconductor package is held in a test socket. The semiconductor package in the test socket electrically makes contact with a test board. A test current is supplied to the semiconductor package through the test board to test the electrical characteristics of the semiconductor package.

In order to test the electrical characteristics, a stable electrical connection should be established between the semiconductor package and the test board. The test socket is used as a medium for connecting the semiconductor package to the test board and in particular, a test socket housing. The test socket housing is disposed between the pads of the semiconductor package and the terminals of the test board to exchange signals between them via pins in contact with both.

With complex and expensive semiconductor packages, reliability of test readings is necessary because semiconductor packages are normally costly and failing a semiconductor package for test socket deficiencies can lead to a needlessly high rejection rate which increases the cost of manufacture. It is normal to test the semiconductor package before soldering it to circuit board and then functionally testing the finished article. If the semiconductor package then fails, scrapping the finished article is extremely expensive both in terms of material and time costs. A complex semiconductor package with densely packed pad contacts is expensive, thus a need exists for test sockets that product accurate and reliable readings.

During testing of the electrical characteristics of the semiconductor package, rapid and continuous insertions and removals of the semiconductor package into and from the test socket place extreme mechanical demands on it and in particular, the test socket housing such that dimensional stability, wear, and compression, ¬¬performance characteristics of the housing degrade and ultimately may affect the accuracy and reliability of the test socket's readings. A need exists for test socket housings that can withstand the rigors of semiconductor package testing, and have dimensional stability, wear, and compression.

Applicants have discovered that test socket housings comprising polyimides and titanium dioxide fillers address the industry needs described herein.

### Test Socket

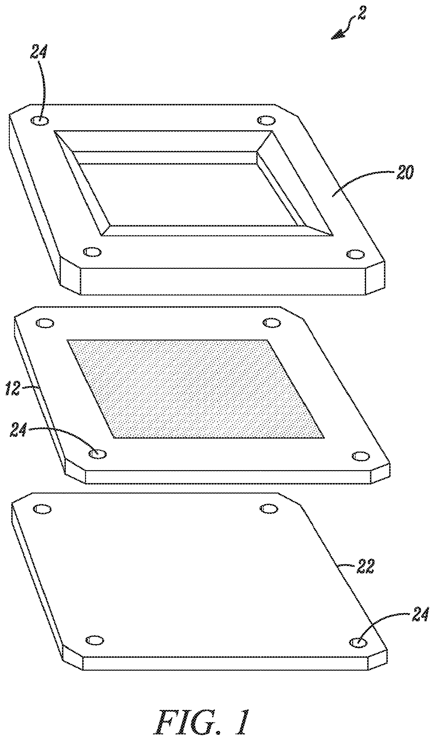

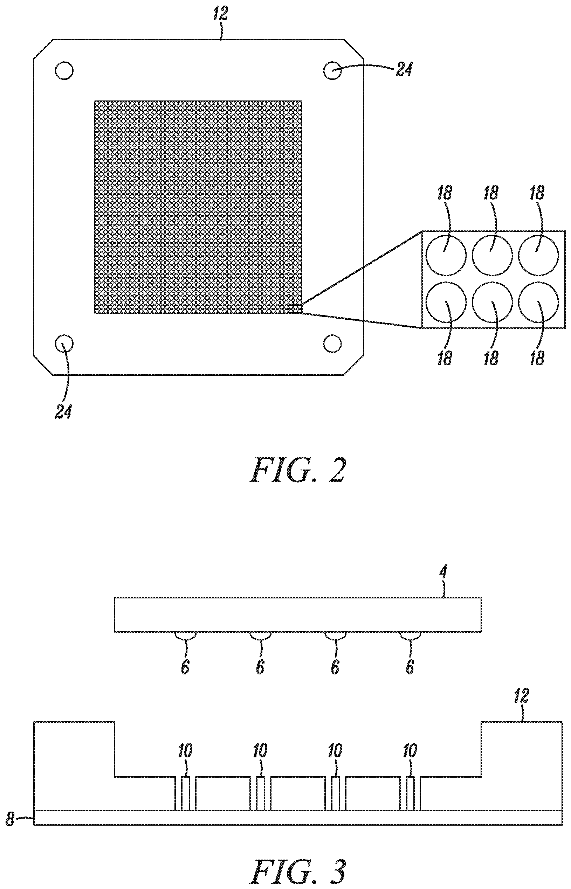

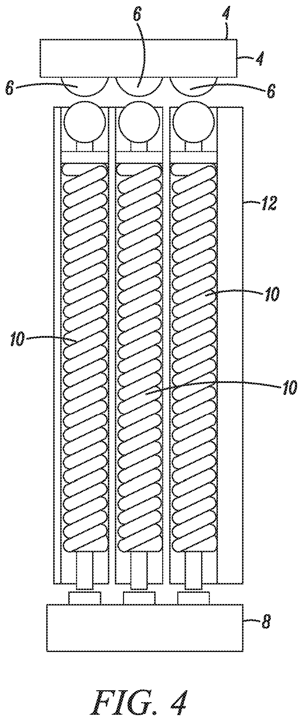

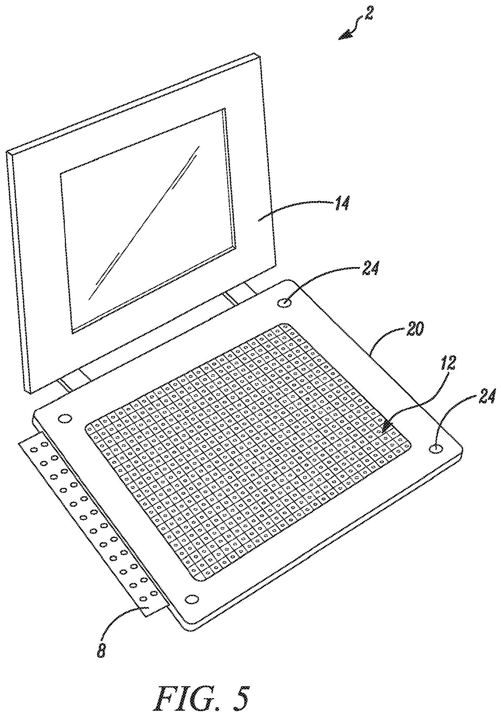

Embodiments of a test socket and test socket housing are shown in FIGS. 1 to 5, in accordance with the present disclosure. Referring to FIGS. 1 to 5, test socket 2 is used to receive successive semiconductor packages 4 in order to perform various quality assurance tests described herein. Semiconductor packages 4 typically include a plurality of electrical terminals 6 that are electrically connected to operative circuitry of the device. Examples of semiconductor packages 4 for use with the test socket of the present invention include but are not limited to ball array, bare die, leadless array, surface mount, and through hole.

Electrical terminals 6 of semiconductor packages 4 are made to be in contact with corresponding terminals (or pads) of a test board 8 via pins 10 in order to access the functionality of the operative circuitry. An example of a test board is a printed circuit board (PCB). Pins 10 include but are not limited to spring pins that compress and connect the circuit.

The test socket 2 is capable of releasably receiving semiconductor packages 4 and biasing electrical terminals 6 thereof against corresponding terminals of test board 8. Thus, quality assurance tests may be performed on a given semiconductor package 4 while in test socket 2 and semiconductor package 4 may be subsequently removed without suffering significant deformation.

Test socket 2 includes a test socket housing 12 that engages semiconductor package 4 and maintains its electrical terminals 6 in registration with the corresponding electrical terminals of test board 8 via pins 10. Test socket 2 may also include a top assembly plate 20 and a bottom assembly plate 22. Plates 20 and 22 function to guide semiconductor package 4 and pins 10 of test socket housing 12 to the correct position for testing.

Test socket 2 may additionally include a lid 14 which is either hinged to top assembly plate 20 along one edge or clipped to top assembly plate 20 along several edges, either of which is intended to clamp semiconductor device 4 onto pins10 as lid 14 is closed. In another embodiment, test socket 2 may include guide holes 24 which for the top plates 20 and 22 to be aligned with test socket housing 12 via screws or securing pins (not shown).

Test sockets and their general design are well known in the industry. The common features of all test sockets are test board pins 10 and a test socket housing 12. The aforementioned is not meant to limit the type of test sockets encompassed by the present invention. Test sockets encompassed by the present invention encompass those that may incorporate a test socket housing having through holes, and disposed between pads of a semiconductor package and terminals of a test board to exchange signals between them. Examples of test sockets include but are not limited to burn-in, development, production, and test contactor sockets. Other examples include ball array, bare die, leadless array, surface mount, and through hole.

### Test Socket Housing

Test socket housing 12 comprises a generally grid-shaped pattern with a plurality of through holes 18 that receive pins 10 and electrical terminals 6 of semiconductor chip package 4.

One having ordinary skill in the art will recognize that the dimensions of socket housing 12 may be matched with the dimensions of semiconductor package 4 and test socket 2. Dimensions include height, width, and depth. Other dimensional aspects include but are not limited to number of through holes, pitch, and through hole diameter. Therefore, when different sizes of semiconductor chip packages 4 are to be tested (as is common when non-standardized chip scale semiconductor packages are tested) and/or different types of test sockets are to be used, socket housing 12 may be changed and/or designed as necessary to match semiconductor chip package 4 and/or test socket 2 without undue experimentation.

One having ordinary skill in the art will also recognize that the term test socket housing is not a standardized term but is synonymous with other descriptions in the art that include but are not limited to a floating guide, a contact plate, guide plate, and an electrical connector. One having ordinary skill in the art will recognize that the term test socket housing encompasses a generally grid-shaped article having through holes, and for use in a test socket where the test socket housing is disposed between pads of a semiconductor package and terminals of a test board to exchange signals between them.

Test socket housing 12 may be made of polymeric resins such as polyimides. The polyimide resins may also include fillers to increase the mechanical performance characteristics of the test socket housing 12 so as to withstand the rigors of semiconductor insertion and removal, and to ultimately allow test socket 2 to make accurate and reliable reading.

### Polyimide Compositions

The compositions used to make the test socket housing and test socket of the present invention may comprise a polyimide powder and a titanium dioxide filler.

### Polyimides

Polyimides as described herein and for use in articles may contain the characteristic -CO-NR-CO- group as a linear or heterocyclic unit along the main chain of the polymer backbone. The polyimide can be obtained, for example, from the reaction of monomers such as an organic tetracarboxylic acid, or the corresponding anhydride or ester derivative thereof, with an aliphatic or aromatic diamine.

A polyimide precursor as used to prepare a polyimide is an organic polymer that becomes the corresponding polyimide when the polyimide precursor is heated or chemically treated. In certain embodiments of the thus-obtained polyimide, about 60 to 100 mole percent, preferably about 70 mole percent or more, more preferably about 80 mole percent or more, of the repeating units of the polymer chain thereof has a polyimide structure as represented, for example, by the following formula: 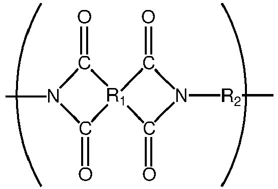 wherein R₁ is a tetravalent aromatic radical having 1 to 5 benzenoid-unsaturated rings of 6 carbon atoms, the four carbonyl groups being directly bonded to different carbon atoms in a benzene ring of the R₁ radical and each pair of carbonyl groups being bonded to adjacent carbon atoms in the benzene ring of the R₁ radical; and R₂ is a divalent aromatic radical having 1 to 5 benzenoid-unsaturated rings of carbon atoms, the two amino groups being directly bonded to different carbon atoms in the benzene ring of the R₂ radical.

Preferred polyimide precursors are aromatic, and provide, when imidized, polyimides in which a benzene ring of an aromatic compound is directly bonded to the imide group. An especially preferred polyimide precursor includes a polyamic acid having a repeating unit represented, for example, by the following general formula, wherein the polyamic acid can be either a homopolymer or copolymer of two or more of the repeating units: 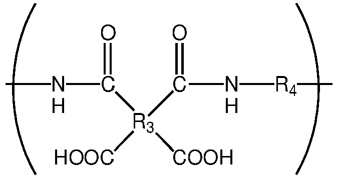 wherein R₃ is a tetravalent aromatic radical having 1 to 5 benzenoid-unsaturated rings of 6 carbon atoms, the four carbonyl groups being directly bonded to different carbon atoms in a benzene ring of the R₃ radical and each pair of carbonyl groups being bonded to adjacent carbon atoms in the benzene ring of the R₃ radical; and R₄ is a divalent aromatic radical having 1 to 5 benzenoid-unsaturated rings of carbon atoms, the two amino groups being directly bonded to different carbon atoms in the benzene ring of the R₄ radical.

Typical examples of a polyamic acid having a repeating unit represented by the general formula above are those obtained from pyromellitic dianhydride ("PMDA") and diaminodiphenyl ether ("ODA") and 3,3',4,4'-biphenyltetracarboxylic dianhydride ("BPDA") and ODA. When subjected to ring closure, the former becomes poly(4,4'-oxydiphenylenepyromellitimide) and the latter becomes poly(4,4'-oxydiphenylene-3,3',4,4'-biphenyltetracarboxy imide).

A typical example of a polyimide prepared by a solution imidization process is a rigid, aromatic polyimide composition having the recurring unit: 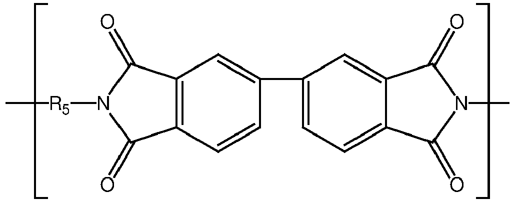 wherein R₅ is *p*-phenylene diamine ("PPD").

Another example of a polyimide prepared by a solution imidization process is a rigid, aromatic polyimide composition wherein R5 is greater than 60 to about 85 mole percent p phenylene diamine ("PPD") units and about 15 to less than 40 mole percent m phenylene diamine ("MPD") units.

The tetracarboxylic acids preferably employed in the practice of the invention, or those from which derivatives useful in the practice of this invention can be prepared, are those having the general formula: 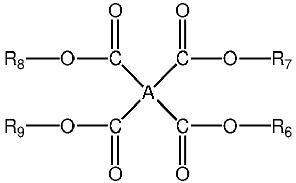 wherein A is a tetravalent organic group and R₆ to R₉, inclusive, comprise hydrogen or a lower alkyl, and preferably methyl, ethyl, or propyl. The tetravalent organic group A preferably has one of the following structures: 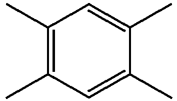 or 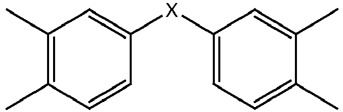 or 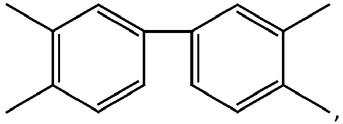 wherein X comprises at least one of -(CO)-, -O-, -S-, -SO₂-, -CH₂-, -C(CH₃)₂-, and -C(CF₃)₂-.

As the aromatic tetracarboxylic acid component, there can be mentioned aromatic tetracarboxylic acids, acid anhydrides thereof, salts thereof and esters thereof. Examples of the aromatic tetracarboxylic acids include 3,3',4,4'-biphenyltetracarboxylic acid, 2,3,3',4'-biphenyltetracarboxylic acid, pyromellitic acid, 3,3',4,4'-benzophenonetetracarboxylic acid, 2,2-bis(3,4-dicarboxyphenyl)propane, bis(3,4-dicarboxyphenyl)methane, bis(3,4-dicarboxyphenyl)ether, bis(3,4-dicarboxyphenyl)thioether, bis(3,4-dicarboxyphenyl)phosphine, 2,2-bis(3',4'-dicarboxyphenyl)hexafluoropropane, 2,2-bis[4-(3,4-dicarboxyphenoxy)phenyl]propane dianhydride, and bis(3,4-dicarboxyphenyl)sulfone.

These aromatic tetracarboxylic acids can be employed singly or in combination. Preferred is an aromatic tetracarboxylic dianhydride, and particularly preferred are 3,3',4,4'-biphenyltetracarboxylic dianhydride, pyromellitic dianhydride, 3,3',4,4'-benzophenonetetracarboxylic dianhydride, and mixtures thereof.

As an organic aromatic diamine, use is preferably made of one or more aromatic and/or heterocyclic diamines, which are themselves known to the art. Such aromatic diamines can be represented by the structure: H₂N-R₁₀-NH₂, wherein R₁₀ is an aromatic group containing up to 16 carbon atoms and, optionally, containing up to one heteroatom in the ring, the heteroatom comprising -N-, -O-, or -S-. Also included herein are those R₁₀ groups wherein R₁₀ is a diphenylene group or a diphenylmethane group. Representative of such diamines are 2,6-diaminopyridine, 3,5-diaminopyridine, m-phenylenediamine, p-phenylene diamine, p,p'-methylene dianiline, 2,6-diaminotoluene, and 2,4-diaminotoluene.

Other examples of the aromatic diamine components, which are merely illustrative, include benzene diamines such as 1,4-diaminobenzene, 1,3-diaminobenzene, and 1,2-diaminobenzene; diphenyl(thio)ether diamines such as 4,4'-diaminodiphenylether, 3,4'-diaminodiphenylether, 3,3'-diaminodiphenylether, and 4,4'-diaminodiphenylthioether; benzophenone diamines such as 3,3'-diaminobenzophenone and 4,4'-diaminobenzophenone; diphenylphosphine diamines such as 3,3'-diaminodiphenylphosphine and 4,4'-diaminodiphenylphosphine; diphenylalkylene diamines such as 3,3'-diaminodiphenylmethane, 4,4'-diaminodiphenylmethane, 3,3'-diaminodiphenylpropane, and 4,4'-diaminodiphenylpropane; diphenylsulfide diamines such as 3,3'-diaminodiphenylsulfide and 4,4'-diaminodiphenylsulfide; diphenylsulfone diamines such as 3,3'-diaminodiphenylsulfone and 4,4'-diaminodiphenylsulfone; and benzidines such as benzidine and 3,3'-dimethylbenzidine.

Other useful diamines have at least one non-heteroatom containing aromatic rings or at least two aromatic rings bridged by a functional group.

These aromatic diamines can be employed singly or in combination. Preferably employed as the aromatic diamine component are 1,4-diaminobenzene, 1,3-diaminobenzene, 4,4'-diaminodiphenylether, and mixtures thereof.

A polyamic acid can be obtained by polymerizing an aromatic diamine component and an aromatic tetracarboxylic acid component preferably in substantially equimolar amounts in an organic polar solvent. The amount of all monomers in the solvent can be in the range of about 5 to about 40 weight percent, more preferably in the range of about 6 to about 35 weight percent, and most preferably in the range of about 8 to about 30 weight percent. The temperature for the reaction generally is not higher than about 100 °C, preferably in the range of about 10 °C to 80 °C. The time for the polymerization reaction generally is in the range of about 0.2 to 60 hours.

The process by which a polyimide is prepared can also vary according to the identity of the monomers from which the polymer is made up. For example, when an aliphatic diamine and a tetracarboxylic acid are polymerized, the monomers form a complex salt at ambient temperature. Heating of such a reaction mixture at a moderate temperature of about 100 to about 150°C yields low molecular weight oligomers (for example, a polyamic acid), and these oligomers can, in turn, be transformed into higher molecular weight polymer by further heating at an elevated temperature of about 240 to about 350°C. When a dianhydride is used as a monomer instead of a tetracarboxylic acid, a solvent such as dimethylacetamide or N-methylpyrrolidinone is typically added to the system. An aliphatic diamine and dianhydride also form oligomers at ambient temperature, and subsequent heating at about 150 to about 200°C drives off the solvent and yields the corresponding polyimide.

As an alternative to the use of an aliphatic diamine and/or an aliphatic diacid or dianhydride, as described above, an aromatic diamine is typically polymerized with a dianhydride in preference to a tetracarboxylic acid, and in such a reaction a catalyst is frequently used in addition to a solvent. A nitrogen-containing base, phenol, or amphoteric material can be used as such a catalyst. Longer periods of heating can be needed to polymerize an aromatic diamine.

The ring closure can also be effected by conventionally used methods such as a heat treatment or a process in which a cyclization agent such as pyridine and acetic anhydride, picoline and acetic anhydride, 2,6-lutidine and acetic anhydride, or the like is used.

Preferred the polyimides used herein are infusible polyimides. In some preferred polyimides essentially all of the connecting groups are imide groups. Preferred polyimides include those made from: a tetracarboxylic anhydride (for example pyromellitic dianhydride and/or 3,3',4,4'-biphenyltetracarboxylic dianhydride) and about 60 to about 85 mole percent p-phenylenediamine and about 15 to about 40 mole percent m-phenylenediamine (see U.S. Patent 5,886,129, which is hereby included by reference); 3,3',4,4'-biphenyltetracarboxylic dianhydride and m-phenylenediamine, maleic anhydride and bis(4-aminophenyl)methane; 3,3',4,4'-benzophenone tetracarboxylic dianhydride, toluenediamine and m-phenylenediamine, 3,3',4,4'-benzophenone tetracarboxylic dianhydride, bis(4-aminophenyl)methane and nadic anhydride; trimellitic anhydride and m-phenylenediamine; trimellitic anhydride and bis(4-aminophenyl)ether; 3,3',4,4'-biphenyltetracarboxylic dianhydride and bis(4-aminophenyl)ether; 3,3',4,4'-biphenyltetracarboxylic dianhydride and m-phenylenediamine; 3,3',4,4'-biphenyltetracarboxylic dianhydride and p-phenylenediamine; 3,3',4,4'-benzophenone tetracarboxylic dianhydride and 4,4'-diaminobenzophenone. An especially preferred polyimide is a polyimide made from a tetracarboxylic anhydride (for example pyromellitic dianhydride and/or 3,3',4,4'-biphenyltetracarboxylic dianhydride) and about 60 to about 85 mole percent p-phenylenediamine and about 15 to about 40 mole percent m-phenylenediamine.

The polyimide composition may comprise from about 40 wt% to about 80 wt% polyimide powder. In embodiments, the polyimide composition comprises 50 wt%, 60 wt%, 70 wt%, and 80 wt% polyimide powder. The polyimide powder may be a polyimide polymer that is a rigid polyaromatic polyimide derived from 3,3',4,4'-biphenyltetracarboxylic acid dianhydride (BPDA) and *p*-phenylenediamine (PPD).

In an embodiment, the polyimide composition comprises from about 40 wt% to about 80 wt% polyimide powder that is a rigid polyaromatic polyimide derived from 3,3',4,4'-biphenyltetracarboxylic acid dianhydride (BPDA) and *p*-phenylenediamine (PPD).

In an embodiment, the polyimides of test socket housing 12 may comprise 40 wt% to 80 wt% of a rigid polyaromatic polyimide derived from 3,3',4,4'-biphenyltetracarboxylic acid dianhydride (BPDA), m-phenylenediamine (MPD), and p-phenylenediamine (PPD).

In an embodiment, the polyimides of test socket housing 12 may comprise 40 wt% to 60 wt% of a rigid polyaromatic polyimide derived from 3,3',4,4'-biphenyltetracarboxylic acid dianhydride (BPDA), m-phenylenediamine (MPD), and p-phenylenediamine (PPD).

The polyimide compositions described herein may include fillers.

### Filler

### Titanium Dioxide

The titanium dioxide described herein may be rutile acicular grade titanium dioxide and referred to herein as acicular titanium dioxide, or may be rutile grade titanium dioxide. The term rutile refers to the crystal type of the titanium dioxide particles and the term acicular refers to the shape of the particles. The rutile titanium dioxide particles described herein are different from acicular rutile titanium dioxide and do not encompass acicular rutile titanium dioxide particles. Both rutile and acicular are terms of art.

The acicular titanium dioxide may have a length of 1.7 microns to 5.15 microns. In an embodiment, the length is about 1.7 microns. In another embodiment, the length is about 2.9 microns. The acicular titanium dioxide may have a diameter of 0.13 microns to 0.27 microns. In an embodiment, the diameter is about 0.13 microns. In another embodiment, the diameter is 0.21 microns.

The rutile titanium dioxide may have median particle size in range from about 0.25 microns to about 0.50 microns. In an embodiment, the median particle size is 0.36 microns.

The titanium dioxide, acicular and rutile, may include surface treatment with alumina, silica, or both. Various surface treatments of titanium dioxide are well known in the art. In an embodiment, the surface treatment is a coating. In another embodiment, the surface treatment is a continuous coating.

The titanium dioxide fillers described herein may be incorporated into the polyimide compositions described herein by adding at any stage during the preparation of polyamic acid. The titanium dioxide filler may be added to the organic solvent prior event to the introduction of the diamine and the dianhydride. It also may be added to the solution in the organic solvent of one or both of the reactants before, during, or after the formation of the polyamic acid. In an embodiment, the titanium dioxide filler is added to a solution of polyamic acid.

The particles may represent from 20% wt% to 60 wt%, of the blend of titanium dioxide and polyimide. The use of less than 5 wt% does not provide a significant increase in dielectric constant. The use of amounts greater than 90 wt% and with some polyimides greater than about 70 wt% (about 200 wt% based on the weight of the polyimide) tends to weaken the product and does limit its usefulness.

In embodiment, the polyimide composition comprises 20% wt% to 60 wt% of acicular titanium dioxide. In another embodiment, the polyimide composition comprises 20% wt% to 60 wt% of rutile titanium dioxide. In another embodiment, the polyimide composition comprises 20% wt% to 60 wt% of acicular titanium dioxide. In another embodiment, the polyimide composition comprises 40% wt% to 60 wt% of rutile titanium dioxide.

Examples of acicular titanium dioxide suitable for use with the polyimide compositions described herein include but is not limited to FTL series of acicular titanium dioxide. In particular, FTL-100, FTL-110, FTL-200, and FTL-300 [(Ishihara Corporation, USA (ISK)].

Examples of rutile titanium dioxide suitable for use with the polyimide compositions described herein include but are not limited to Ti-Pure™ grades of rutile titanium dioxide. In particular, R-706 titanium dioxide [The Chemours Company, Wilmington, DE, USA).

### Polyimide Composition Continued

The polyimide composition may comprise 40 wt% to 60 wt% of a rigid polyaromatic polyimide derived from 3,3',4,4'-biphenyltetracarboxylic acid dianhydride (BPDA) and *p*-phenylenediamine (PPD); and 20 wt% to 80 wt% of acicular titanium dioxide.

In an embodiment, the polyimide composition comprises 50 wt% of a rigid polyaromatic polyimide derived from 3,3',4,4'-biphenyltetracarboxylic acid dianhydride (BPDA) and p-phenylenediamine (PPD) and 50 wt% acicular titanium dioxide.

In another embodiment, polyimide composition comprises 60 wt% of a rigid polyaromatic polyimide derived from 3,3',4,4'-biphenyltetracarboxylic acid dianhydride (BPDA) and *p*-phenylenediamine (PPD); and 40% wt% acicular titanium dioxide.

The polyimide composition may comprise 40 wt% to 60 wt% of a rigid polyaromatic polyimide derived from 3,3',4,4'-biphenyltetracarboxylic acid dianhydride (BPDA) and *p*-phenylenediamine (PPD); and 20 wt% to 80 wt% of rutile titanium dioxide.

In an embodiment, the polyimide composition comprises 50 wt% of a rigid polyaromatic polyimide derived from 3,3',4,4'-biphenyltetracarboxylic acid dianhydride (BPDA) and *p*-phenylenediamine (PPD) and 50 wt% rutile titanium dioxide.

In another embodiment, the polyimide composition comprises 70 wt% of a rigid polyaromatic polyimide derived from 3,3',4,4'-biphenyltetracarboxylic acid dianhydride (BPDA) and *p*-phenylenediamine (PPD) and 30 wt% rutile titanium dioxide.

In another embodiment, the polyimide composition comprises 80 wt% of a rigid polyaromatic polyimide derived from 3,3',4,4'-biphenyltetracarboxylic acid dianhydride (BPDA) and *p*-phenylenediamine (PPD) and 20 wt% rutile titanium dioxide.

### Test Socket Compositions

Test socket housing 12 may comprise a polyimide polymer and acicular titanium dioxide. In another embodiment, test socket housing 12 may comprise 40 wt% to 80 wt% of a rigid polyaromatic polyimide derived from 3,3',4,4'-biphenyltetracarboxylic acid dianhydride (BPDA), m-phenylenediamine (MPD), and p-phenylenediamine (PPD); and 20 wt% to 60 wt% of acicular titanium dioxide. In another embodiment, test socket housing 12 may comprise 40 wt% to 60 wt% of a rigid polyaromatic polyimide derived from 3,3',4,4'-biphenyltetracarboxylic acid dianhydride (BPDA), m-phenylenediamine (MPD), and p-phenylenediamine (PPD); and 40 wt% to 60 wt% of acicular titanium dioxide.

In an embodiment, test socket housing 12 comprises 50 wt%, 52 wt%, 57 wt%, or 60 wt% of a rigid polyaromatic polyimide derived from 3,3',4,4'-biphenyltetracarboxylic acid dianhydride (BPDA), m-phenylenediamine (MPD), and p-phenylenediamine (PPD).

In an embodiment, test socket housing 12 comprises 50 wt%, 48 wt%, 43 wt%, or 40 wt% acicular titanium dioxide.

Test socket housing 12 may comprise 50 wt%, 52 wt%, 57 wt%, or 60 wt% of a rigid polyaromatic polyimide derived from 3,3',4,4'-biphenyltetracarboxylic acid dianhydride (BPDA), m-phenylenediamine (MPD); and p-phenylenediamine (PPD) in combination with 50 w%, 48 wt%, 43 wt%, or 40 wt% acicular titanium dioxide.

In an embodiment, test socket housing 12 comprises 50 wt% of a rigid polyaromatic polyimide derived from 3,3',4,4'-biphenyltetracarboxylic acid dianhydride (BPDA), m-phenylenediamine (MPD), and p-phenylenediamine (PPD); and 50% wt% acicular titanium dioxide.

In another embodiment, test socket housing 12 comprises 52 wt% of a rigid polyaromatic polyimide derived from 3,3',4,4'-biphenyltetracarboxylic acid dianhydride (BPDA), m-phenylenediamine (MPD), and p-phenylenediamine (PPD); and 48% wt% acicular titanium dioxide.

In another embodiment, test socket housing 12 comprises 57 wt% of a rigid polyaromatic polyimide derived from 3,3',4,4'-biphenyltetracarboxylic acid dianhydride (BPDA), m-phenylenediamine (MPD), and p-phenylenediamine (PPD); and 43% wt% acicular titanium dioxide.

In another embodiment, test socket housing 12 comprises 60 wt% of a rigid polyaromatic polyimide derived from 3,3',4,4'-biphenyltetracarboxylic acid dianhydride (BPDA), m-phenylenediamine (MPD), and p-phenylenediamine (PPD); and 40% wt% acicular titanium dioxide.

Test socket housing 12 may comprise a polyimide polymer and rutile titanium dioxide. In another embodiment, test socket housing 12 may comprise 40 wt% to 80 wt% of a rigid polyaromatic polyimide derived from 3,3',4,4'-biphenyltetracarboxylic acid dianhydride (BPDA), *m*-phenylenediamine (MPD), and *p*-phenylenediamine (PPD); and 20 wt% to 60 wt% of rutile titanium dioxide. In another embodiment, test socket housing 12 may comprise 40 wt% to 60 wt% of a rigid polyaromatic polyimide derived from 3,3',4,4'-biphenyltetracarboxylic acid dianhydride (BPDA), *m*-phenylenediamine (MPD), and *p*-phenylenediamine (PPD); and 40 wt% to 60 wt% of rutile titanium dioxide. In another embodiment, test socket housing 12 may comprise 70 wt% of a rigid polyaromatic polyimide derived from 3,3',4,4'-biphenyltetracarboxylic acid dianhydride (BPDA), *m*-phenylenediamine (MPD), and *p*-phenylenediamine (PPD); and 30 wt% of rutile titanium dioxide.

In an embodiment, test socket housing 12 comprises 50 wt% or 60 wt% of a rigid polyaromatic polyimide derived from 3,3',4,4'-biphenyltetracarboxylic acid dianhydride (BPDA), *m*-phenylenediamine (MPD), and *p*-phenylenediamine (PPD).

In an embodiment, test socket housing 12 comprises 50 wt% or 40 wt% rutile titanium dioxide.

Test socket housing 12 may comprise 50 wt or 60 wt% of a rigid polyaromatic polyimide derived from 3,3',4,4'-biphenyltetracarboxylic acid dianhydride (BPDA), *m-*phenylenediamine (MPD), and *p*-phenylenediamine (PPD) in combination with 50 w% or 40 wt% rutile titanium dioxide.

In an embodiment, test socket housing 12 comprises 50 wt% of a rigid polyaromatic polyimide derived from 3,3',4,4'-biphenyltetracarboxylic acid dianhydride (BPDA), *m*-phenylenediamine (MPD), and *p*-phenylenediamine (PPD); and 50% wt% rutile titanium dioxide.

In another embodiment, test socket housing 12 comprises 60 wt% of a rigid polyaromatic polyimide derived from 3,3',4,4'-biphenyltetracarboxylic acid dianhydride (BPDA), *m*-phenylenediamine (MPD), and *p*-phenylenediamine (PPD); and 40% wt% rutile titanium dioxide.

The titanium dioxide-filled polyimide compositions described herein may be made, and shapes and parts made from, by techniques normally used for making shapes and parts from infusible polymeric materials, namely by the application of heat and pressure to powder mixtures of various ingredients as described in U.S. Pat. No. 4,360,626.

Blanks for testing may be prepared according to above and then machined to the final article dimensions as required. One having ordinary skill in the art in the process of making blanks and machining them will recognize that various dimensions of articles may be formed without undo experimentation, and via blank forming and machining process commonly used in the industry.

### Examples

In the Examples; tensile strength, elongations %, modulus, and flex modulus are measured using ASTM D1708 and ASTM D790. All test pieces were molded from the titanium dioxide-filled polyimide compositions described herein using a procedure substantially according to the procedure described in U.S. Pat. No. 4,360,626 (especially column 2, lines 54-60).

The exemplary compounds identified by "E" in the table below are intended only to further illuminate and not to limit the scope of compounds, processes, and articles described and recited herein. Comparative examples are identified in the table below by "C".

In the Examples, the following abbreviations are used: BPDA (3,3',4,4'-biphenyltetracarboxylic anhydride); MPD (m-phenylenediamine); and PPD (p-phenylenediamine).

Acicular titanium dioxide filler used in the examples E described herein are from the FTL series of acicular titanium dioxide. In particular, FTL-100, FTL-110, FTL-200, and FTL-300 [(Ishihara Corporation, USA (ISK)].

Rutile titanium dioxide filler used in the examples E described herein are from Ti-Pure™ grades of rutile titanium dioxide. In particular, R-706 titanium dioxide [The Chemours Company, Wilmington, DE, USA).

### Polyamide Compositions: BPDA, MPD, and PPD Derived with, Acicular Titanium Dioxide

The following examples for polyimide compositions having acicular titanium dioxide (exemplary and comparative) are listed in Table 1.

### EXAMPLE 1

Particles of a polyimide composition containing 52% of a polyimide made from BPDA, PPD, & MPD (1:1 molar ratio BPDA to combined PPD and MPD; and 70/30 wt% ratio of PPD/MPD) and 48 wt% acicular titanium dioxide (FTL-100) were prepared according to the method described in U.S. Pat. No. 5,886,129 (specifically example 7). The particles were milled and passed through a 20 mesh screen and used to prepare tensile bar samples. Bars made were measured to have a tensile strength of 23763 MPa, elongation of 1.6%, modulus of 16073 MPa, and flex modulus of 13339 MPa.

### EXAMPLE 2

Particles of a polyimide composition containing 60% of a polyimide made from BPDA, PPD, & MPD (1:1 molar ratio BPDA to combined PPD and MPD; and 70/30 wt% ratio of PPD/MPD) and 40 wt% acicular titanium dioxide (FTL-100) were prepared according to the method described in U.S. Pat. No. 5,886,129 (specifically example 7). The particles were milled and passed through a 20 mesh screen and used to prepare tensile bar samples. Bars made were measured to have a tensile strength of 26304 MPa, elongation of 3%, modulus of 13259 MPa, and flex modulus of 13406 MPa.

### EXAMPLE 3

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% acicular titanium dioxide (FTL-110) were prepared according to the method described in U.S. Pat. No. 5,886,129 (specifically example 7). The particles were milled and passed through a 20 mesh screen and used to prepare tensile bar samples. Bars made were measured to have a tensile strength of 27096 MPa, elongation of 2.2%, modulus of 16334 MPa, and flex modulus of 17279 MPa.

### EXAMPLE 4

Particles of a polyimide composition containing 57% of a polyimide made from BPDA, PPD, & MPD (1:1 molar ratio BPDA to combined PPD and MPD; and 70/30 wt% ratio of PPD/MPD) and 43 wt% acicular titanium dioxide (FTL-110) were prepared according to the method described in U.S. Pat. No. 5,886,129 (specifically example 7). The particles were milled and passed through a 20 mesh screen and used to prepare tensile bar samples. Bars made were measured to have a tensile strength of 25908 MPa, elongation of 2.5%, modulus of 15463 MPa, and flex modulus of 14461 MPa.

### EXAMPLE 5

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% acicular titanium dioxide (FTL-200) were prepared according to the method described in U.S. Pat. No. 5,886,129 (specifically example 7). The particles were milled and passed through a 20 mesh screen and used to prepare tensile bar samples. Bars made were measured to have a tensile strength of 2332 MPa, elongation of 2.1%, modulus of 13526 MPa, and flex modulus of 16503 MPa.

### EXAMPLE 6

Particles of a polyimide composition containing 60% of a polyimide made from BPDA, PPD, & MPD (1:1 molar ratio BPDA to combined PPD and MPD; and 70/30 wt% ratio of PPD/MPD) and 40 wt% acicular titanium dioxide (FTL-300) were prepared according to the method described in U.S. Pat. No. 5,886,129 (specifically example 7). The particles were milled and passed through a 20 mesh screen and used to prepare tensile bar samples. Bars made were measured to have a tensile strength of 23389 MPa, elongation of 2.5%, modulus of 12108 MPa, and flex modulus of 12569 MPa.

### COMPARATIVE EXAMPLE 1

DuPont™Vespel®SCP-5000 grade resin (an unfilled polyimide resin) was used to prepare tensile bars. Bars made were measured to have a tensile strength of 22962 MPa, elongation of 6.2%, modulus of 5770 MPa, and flex modulus of 5630 MPa. DuPont™Vespel®SCP-5000 grade resin is available from E.I. DuPont de Nemours & Co., Wilmington, DE, USA.

### COMPARATIVE EXAMPLE 2

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% synthetic graphite (bulk density of 0.100 g/cc; particle size of 5.0 µm at a density of 1.81 g/cc; and d50 commercially available from Imerys Graphite & Carbon, Switzerland) were prepared according to the method described in U.S. Pat. No. 5,886,129 (specifically example 7). The particles were milled and passed through a 20 mesh screen and used to prepare tensile bar samples. Bars made were measured to have a tensile strength of 1200 MPa, elongation of 2.0%, modulus of 9000 MPa, and flex modulus of 8220 MPa. DuPont™Vespel®SCP-5050 grade resin is available from E.I. DuPont de Nemours & Co., Wilmington, DE, USA.

**Table 1**

| Sample | E1 | E2 | E3 | E4 | E5 | E6 | C1 | C2 |
|---|---|---|---|---|---|---|---|---|
| Tensile Strength | 23763 | 26304 | 27096 | 25908 | 23332 | 23389 | 22962 | 12000 |
| Elongation % | 1.6 | 3 | 2.2 | 2.5 | 2.1 | 2.5 | 6.2 | 2 |
| Modulus (MPa) | 16073 | 13259 | 16334 | 15463 | 13526 | 12108 | 5770 | 9000 |
| Flex Modulus (MPa) | 13339 | 13406 | 17279 | 14461 | 16503 | 12569 | 5630 | 8220 |
| Filler | *48% | *40% | **50% | **43% | 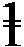 50% | 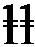 40% | 0% | Gr50% |

| | | | | | | | | |
|---|---|---|---|---|---|---|---|---|
| * FTL-100, ** FTL-110, 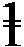 FTL200, 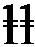 FTL300, Gr graphite. | | | | | | | | |

### Polyamide Compositions: BPDA, MPD, and PPD Derived, with Rutile Titanium Dioxide

The following examples for polyimide compositions having rutile titanium dioxide (exemplary and comparative) are listed in Table 2.

### EXAMPLE 7

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 21252 MPa, elongation of 2.0%, modulus of 9701 MPa, and flex modulus of 11537 MPa.

### EXAMPLE 8

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 21252 MPa, elongation of 2.9%, modulus of 10802 MPa, and flex modulus of 11695 MPa.

### EXAMPLE 9

Particles of a polyimide composition containing 60% of a polyimide made from BPDA, PPD, & MPD (1:1 molar ratio BPDA to combined PPD and MPD; and 70/30 wt% ratio of PPD/MPD) and 40 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 16938 MPa, elongation of 1.7%, modulus of 9352 MPa, and flex modulus of 9667 MPa.

### EXAMPLE 10

Particles of a polyimide composition containing 63% of a polyimide made from BPDA, PPD, & MPD (1:1 molar ratio BPDA to combined PPD and MPD; and 70/30 wt% ratio of PPD/MPD) and 37 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 21857 MPa, elongation of 4.0%, modulus of 8316 MPa, and flex modulus of 8756 MPa.

### EXAMPLE 11

Particles of a polyimide composition containing 70% of a polyimide made from BPDA, PPD, & MPD (1:1 molar ratio BPDA to combined PPD and MPD; and 70/30 wt% ratio of PPD/MPD) and 30 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 20939 MPa, elongation of 3.9%, modulus of 7306 MPa, and flex modulus of 7384 MPa.

### COMPARATIVE EXAMPLE 3

DuPont™Vespel®SCP-5000 grade resin (an unfilled polyimide resin) was used to prepare tensile bars. Bars made were measured to have a tensile strength of 22962 MPa, elongation of 6.2%, modulus of 5770 MPa, and flex modulus of 5630 MPa. DuPont™Vespel®SCP-5000 grade resin is available from E.I. DuPont de Nemours & Co., Wilmington, DE, USA.

**Table 2**

| Sample | E7 | E8 | E9 | E10 | E11 | C3 | C4 |
|---|---|---|---|---|---|---|---|
| Tensile Strength | 21252 | 21252 | 16938 | 21857 | 20939 | 22962 | 12000 |
| Elongation % | 2.0 | 2.9 | 1.7 | 4.0 | 3.9 | 6.2 | 2 |
| Modulus (MPa) | 9701 | 10802 | 9352 | 8316 | 7306 | 5770 | 9000 |
| Flex Modulus (MPa) | 11537 | 11695 | 9667 | 8756 | 7384 | 5630 | 8220 |
| Filler | 50% | 50% | 40% | 37% | 30% | 0% | Gr50% |

| | | | | | | | |
|---|---|---|---|---|---|---|---|
| Gr graphite. | | | | | | | |

### COMPARATIVE EXAMPLE 4

Particles of a polyimide composition containing 50% of a polyimide made from BPDA, PPD, & MPD (1:1 molar ratio BPDA to combined PPD and MPD; and 70/30 wt% ratio of PPD/MPD) and 50 wt% synthetic graphite (bulk density of 0.100 g/cc; particle size of 5.0 µm at a density of 1.81 g/cc; and d50 commercially available from Imerys Graphite & Carbon, Switzerland) were prepared according to the method described in U.S. Pat. No. 5,886,129 (specifically example 7). The particles were milled and passed through a 20 mesh screen and used to prepare tensile bar samples. Bars made were measured to have a tensile strength of 1200 MPa, elongation of 2.0%, modulus of 9000 MPa, and flex modulus of 8220 MPa. DuPont™Vespel®SCP-5050 grade resin is available from E.I. DuPont de Nemours & Co., Wilmington, DE, USA.

### Polyamide Compositions: BPDA and PPD Derived, with Acicular Titanium Dioxide

The following examples for polyimide compositions having acicular titanium dioxide (exemplary and comparative) are listed in Tables 3 and 4.

### EXAMPLE 12

Particles of a polyimide composition containing 50% of a polyimide made from BPDA & PPD (1:1 molar ratio BPDA to PPD; and 50 wt% acicular titanium dioxide (FTL-100) were prepared according to the method described in U.S. Pat. No. 5,886,129 (specifically example 7). The particles were milled and passed through a 20 mesh screen and used to prepare tensile bar samples. Bars made were measured to have a tensile strength of 16307 MPa, elongation of 0.9%, and tensile modulus of 16285 MPa (2361944 PSI).

### EXAMPLE 13

Particles of a polyimide composition containing 60% of a polyimide made from BPDA & PPD (1:1 molar ratio BPDA to PPD; and 40 wt% acicular titanium dioxide (FTL-110) were prepared according to the method described in U.S. Pat. No. 5,886,129 (specifically example 7). The particles were milled and passed through a 20 mesh screen and used to prepare tensile bar samples. Bars made were measured to have a tensile strength of 21403 MPa, elongation of 1.7%, tensile modulus of 13010 MPa (1886882 PSI) and flex modulus of 13118 MPa.

### EXAMPLE 14

Particles of a polyimide composition containing 50% of a polyimide made from BPDA & PPD (1:1 molar ratio BPDA to PPD; and and 50 wt% acicular titanium dioxide (FTL-110) were prepared according to the method described in U.S. Pat. No. 5,886,129 (specifically example 7). The particles were milled and passed through a 20 mesh screen and used to prepare tensile bar samples. Bars made were measured to have a tensile strength of 20665 MPa, elongation of 1.6%, tensile modulus of 14092 MPa (2043845 PSI) and flex modulus of 15647 MPa.

### EXAMPLE 15

Particles of a polyimide composition containing 50% of a polyimide made from BPDA & PPD (1:1 molar ratio BPDA to PPD; and 50 wt% acicular titanium dioxide (FTL-200) were prepared according to the method described in U.S. Pat. No. 5,886,129 (specifically example 7). The particles were milled and passed through a 20 mesh screen and used to prepare tensile bar samples. Bars made were measured to have a tensile strength of 17176 MPa, elongation of 1.2%, and tensile modulus of 13547 MPa (1964772 PSI).

### COMPARATIVE EXAMPLE 5

Particles of a polyimide composition containing 97.6% of a polyimide made from BPDA & PPD (1:1 molar ratio BPDA to PPD; and 2.4 wt% synthetic graphite (bulk density of 0.100 g/cc; particle size of 5.0 µm at a density of 1.81 g/cc; and d50 commercially available from Imerys Graphite & Carbon, Switzerland) were prepared according to the method described in U.S. Pat. No. 5,886,129 (specifically example 7). The particles were milled and passed through a 20 mesh screen and used to prepare tensile bar samples. Bars made were measured to have a tensile strength of 18553 MPa, elongation of 2.9%, and tensile modulus of 6562 MPa (951662 PSI).

### COMPARATIVE EXAMPLE 6

Particles of a polyimide composition containing 70% of a polyimide made from BPDA & PPD (1:1 molar ratio BPDA to PPD; and 30 wt% synthetic graphite (bulk density of 0.100 g/cc; particle size of 5.0 µm at a density of 1.81 g/cc; and d50 commercially available from Imerys Graphite & Carbon, Switzerland) were prepared according to the method described in U.S. Pat. No. 5,886,129 (specifically example 7). The particles were milled and passed through a 20 mesh screen and used to prepare tensile bar samples. Bars made were measured to have a tensile strength of 13549 MPa, elongation of 2.9%, and tensile modulus of 7041 MPa (1021216 PSI).

### COMPARATIVE EXAMPLE 7

Particles of a polyimide composition containing 50% of a polyimide made from BPDA & PPD (1:1 molar ratio BPDA to PPD; and 50 wt% synthetic graphite (bulk density of 0.100 g/cc; particle size of 5.0 µm at a density of 1.81 g/cc; and d50 commercially available from Imerys Graphite & Carbon, Switzerland) were prepared according to the method described in U.S. Pat. No. 5,886,129 (specifically example 7). The particles were milled and passed through a 20 mesh screen and used to prepare tensile bar samples. Bars made were measured to have a tensile strength of 10603 MPa, elongation of 1.9%, and tensile modulus of 8574 MPa (1243534 PSI).

### COMPARATIVE EXAMPLE 8

Particles of a polyimide composition containing 100% of a polyimide made from BPDA & PPD (1:1 molar ratio BPDA to PPD were prepared according to the method described in U.S. Pat. No. 5,886,129 (specifically example 7). The particles were milled and passed through a 20 mesh screen and used to prepare tensile bar samples. Bars made were measured to have a tensile strength of 19603 MPa and elongation of 3.2%.

For the SI values of the Tensile Modulus see supra.

**Table 3**

| Sample | E12 | E13 | E14 | E15 |
|---|---|---|---|---|
| Tensile Strength | 16307 | 21403 | 20665 | 17176 |
| Elongation % | 0.9 | 1.7 | 1.6 | 1.2 |
| Tensile Modulus (PSI) | 2361944 | 1886882 | 2043845 | 1964772 |
| Flex Modulus (MPa) | - | 13118 | 15647 | - |
| Filler | *50% | **40% | **50% | 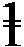 50% |

| | | | | |
|---|---|---|---|---|
| * FTL-100, ** FTL-110, 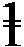 FTL200, Gr graphite | | | | |

**Table 4**

| Sample | C5 | C6 | C7 | C8 |
|---|---|---|---|---|
| Tensile Strength | 18553 | 13549 | 10603 | 19603 |
| Elongation % | 2.9 | 2.9 | 1.9 | 3.2 |
| Tensile Modulus (PSI) | 951663 | 1021216 | 1243534 | - |
| Flex Modulus (MPa) | - | - | - | - |
| Filler | Gr2.4% | Gr30% | Gr50% | 0% |

| | | | | |
|---|---|---|---|---|
| Gr graphite. | | | | |

### Polyamide Compositions: BPDA and PPD Derived, with Rutile Titanium Dioxide

The following examples for polyimide compositions having acicular titanium dioxide (exemplary and comparative) are listed in Table 5.

### EXAMPLE 16

Particles of a polyimide composition containing 50% of a polyimide made from BPDA & PPD (1:1 molar ratio BPDA to PPD; and 50 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 18045 MPa, elongation of 1.7%, tensile modulus of 10844 MPa (1572774 PSI) and flex modulus of 12790 MPa.

### EXAMPLE 17

Particles of a polyimide composition containing 70% of a polyimide made from BPDA & PPD (1:1 molar ratio BPDA to PPD; and 30 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 16776 MPa, elongation of 1.9%, and tensile modulus of 9191MPa (1333009 PSI).

### EXAMPLE 18

Particles of a polyimide composition containing 80% of a polyimide made from BPDA & PPD (1:1 molar ratio BPDA to PPD; and 20 wt% rutile titanium dioxide (R-706) were prepared according to the method described in U.S. Pat. No. 5,886,129 (specifically example 7). The particles were milled and passed through a 20 mesh screen and used to prepare tensile bar samples. Bars made were measured to have a tensile strength of 14045 MPa, elongation of 1.5%, and tensile modulus of 9098 MPa (1319481 PSI.

Comparative examples 5, 6, 7, and 8 are the same as in Table 4 above
For the SI values of the tensile modulus see supra.

**Table 5**

| Sample | E16 | E17 | E18 | C1 | C2 | C3 | C4 |
|---|---|---|---|---|---|---|---|
| Tensile Strength | 18045 | 16776 | 14045 | 18553 | 13549 | 10603 | 16708 |
| Elongation % | 1.7 | 1.9 | 1.5 | 2.9 | 2.9 | 1.9 | 2.4 |
| Tensile Modulus (PSI) | 1572774 | 1333009 | 1319481 | 951663 | 1021216 | 1243534 | 6676 (MPa) |
| Flex Modulus (MPa) | 12790 | - | - | - | - | - | - |
| Filler | 50% | 30% | 20% | Gr2.4% | Gr30% | Gr50% | 0% |

| | | | | | | | |
|---|---|---|---|---|---|---|---|
| Gr graphite | | | | | | | |

## Claims

1. A test socket housing having through-holes vertically extending through the housing, wherein the housing comprises:
a) 40 wt% - 80 wt% polyimide polymer; and
b) 20 wt% - 60 wt% rutile titanium dioxide or acicular titanium dioxide.

2. The test socket housing according to claim 1, wherein the polyimide polymer is a rigid polyaromatic polyimide derived from 3,3',4,4'-biphenyltetracarboxylic acid dianhydride (BPDA), m-phenylenediamine (MPD), and p-phenylenediamine (PPD).

3. The test socket housing according to claim 2 comprising the polyimide polymer in a range from 40 wt% to 60 wt%.

4. The test socket housing according to claim 1, wherein the polyimide polymer is a rigid polyaromatic polyimide derived from 3,3',4,4'-biphenyltetracarboxylic acid dianhydride (BPDA) and p-phenylenediamine (PPD).

5. The test socket housing according to any one of claims 1 to 4, wherein the rutile titanium dioxide has a median particle size in a range from 0.25 microns to 0.50 microns.

6. The test socket housing according to any one of claims 1 to 5, wherein the acicular titanium dioxide has a length of about 1.7 microns to about 5.15 microns.

7. The test socket housing according to any one of claims 1 to 6, wherein rutile titanium dioxide and the acicular titanium dioxide are surfaced treated with alumina.

8. The test socket housing according to any one of claims 1 to 7, wherein rutile titanium dioxide or acicular titanium dioxide is in a range from 40 wt% to 60 wt%.

9. A test socket comprising: a test socket housing of any one of claims 1 to 8.

## Patentansprüche

1. Testsockelgehäuse, das Durchgangsbohrungen aufweist, die sich senkrecht durch das Gehäuse erstrecken, wobei das Gehäuse Folgendes umfasst:
a) 40 Gew.-% bis 80 Gew.-% Polyimidpolymer ; und
b) 20 Gew.-% bis 60 Gew.-% Rutiltitandioxid oder nadelförmiges Titandioxid.

2. Testsockelgehäuse nach Anspruch 1, wobei das Polyimidpolymer ein steifes polyaromatisches Polyimid ist, das von 3,3',4,4'-Biphenyltetracarbonsäuredianhydrid (BPDA), m-Phenylendiamin (MPD) und p-Phenylendiamin (PPD) abgeleitet ist.

3. Testsockelgehäuse nach Anspruch 2, umfassend das Polyimidpolymer in einem Bereich von 40 Gew.-% bis 60 Gew.-%.

4. Testsockelgehäuse nach Anspruch 1, wobei das Polyimidpolymer ein steifes polyaromatisches Polyimid ist, das von 3,3',4,4'-Biphenyltetracarbonsäuredianhydrid (BPDA) und p-Phenylendiamin (PPD) abgeleitet ist.

5. Testsockelgehäuse nach einem der Ansprüche 1 bis 4, wobei das Rutiltitandioxid eine mittlere Teilchengröße in einem Bereich von 0,25 Mikron bis 0,50 Mikron aufweist.

6. Testsockelgehäuse nach einem der Ansprüche 1 bis 5, wobei das nadelförmige Titandioxid eine Länge von etwa 1,7 Mikron bis etwa 5,15 Mikron aufweist.

7. Testsockelgehäuse nach einem der Ansprüche 1 bis 6, wobei das Rutiltitandioxid und das nadelförmige Titandioxid mit Aluminiumoxid oberflächenbehandelt werden.

8. Testsockelgehäuse nach einem der Ansprüche 1 bis 7, wobei das Rutiltitandioxid oder das nadelförmige Titandioxid in einem Bereich von 40 Gew.-% bis 60 Gew.-% liegen.

9. Testsockel umfassend: ein Testsockelgehäuse nach einem der Ansprüche 1 bis 8.

## Revendications

1. Boîtier de socle d'essai comportant des trous traversant s'étendant verticalement à travers le boîtier, dans lequel le boîtier comprend :
a) 40 % en poids à 80 % en poids d'un polymère polyimide, et
b) 20 % en poids à 60 % en poids de dioxyde de titane rutile ou de dioxyde de titane aciculaire.

2. Boîtier de socle d'essai selon la revendication 1, dans lequel le polymère polyimide est un polyimide polyaromatique rigide dérivé de dianhydride d'acide 3,3',4,4'-biphényl-tétracarboxylique (BPDA), de m-phénylènediamine (MPD) et de p-phénylènediamine (PPD).

3. Boîtier de socle d'essai selon la revendication 2, comprenant le polymère polyimide dans une plage de 40 % en poids à 60 % en poids.

4. Boîtier de socle d'essai selon la revendication 1, dans lequel le polymère polyimide est un polyimide polyromatique rigide dérivé de dianhydride d'acide 3,3',4,4'-biphényl-tétracarboxylique (BPDA) et de *p*-phénylènediamine (PPD).

5. Boîtier de socle d'essai selon l'une quelconque des revendications 1 à 4, dans lequel le dioxyde de titane rutile a une taille moyenne de particule dans une plage de 0,25 microns à 0,50 microns.

6. Boîtier de socle d'essai selon l'une quelconque des revendications 1 à 5, dans lequel le dioxyde de titane aciculaire a une longueur d'environ 1,7 microns a environ 5,15 microns.

7. Boîtier de socle d'essai selon l'une quelconque des revendications 1 à 6, dans lequel le dioxyde de titane rutile et le dioxyde de titane aciculaire sont traités en surface avec de l'alumine.

8. Boîtier de socle d'essai selon l'une quelconque des revendications 1 à 7, dans lequel le dioxyde de titane rutile ou le dioxyde de titane aciculaire est présent dans une plage de 40 % en poids à 60 % en poids.

9. Socle d'essai comprenant : un boîtier de socle d'essai selon l'une quelconque des revendications 1 à 8.
